# EUROPEAN PATENT APPLICATION

(11) **EP 4 471 443 A1**
(43) Date of publication of application: **04.12.2024**
(21) Application number: 23886279.1
(22) Date of filing: 01.11.2023
(51) Int. Cl.: G01R 31/392, G01R 31/396, G01R 19/165, G01R 31/367

(54) **APPARATUS AND METHOD FOR DIAGNOSING BATTERY**

(30) Priority: 01.11.2022 KR 20220143795
(71) Applicant: LG Energy Solution, Ltd., Seoul 07335 (KR)
(72) Inventor: BAE, Yoon-Jung, Daejeon 34122 (KR); WOO, Kyung-Hwa, Daejeon 34122 (KR); CHA, A-Ming, Daejeon 34122 (KR)
(74) Representative: Goddar, Heinz J.
(86) International application number: PCT/KR2023/017288
(87) International publication number: WO 2024/096583

(57) **Abstract**

An apparatus for diagnosing a battery according to an embodiment of the present disclosure includes a profile obtaining unit configured to obtain a differential profile representing the corresponding relationship between a voltage of a battery and a differential capacity for the voltage; and a control unit configured to determine a target peak from the differential profile, determine a first comparison result that compares the voltage between a reference peak of a reference profile preset for the battery and the determined target peak and a second comparison result that compares the differential capacity between the reference peak and the determined target peak, and judge a state of the battery based on the first comparison result and the second comparison result.

## Description

### TECHNICAL FIELD

The present application claims priority to Korean Patent Application No. 10-2022-0143795 filed on November 1, 2022 in the Republic of Korea, the disclosures of which are incorporated herein by reference.

The present disclosure relates to an apparatus and method for diagnosing a battery, and more particularly, to an apparatus and method for diagnosing a battery, which is capable of diagnosing a state of a battery in a non-destructive manner.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Generally, a battery includes a positive electrode and a negative electrode, and the battery has the characteristic of deteriorating as it is used. Additionally, the degree of deterioration of the positive electrode and the negative electrode may vary depending on various causes such as usage environment and usage history of the battery.

Additionally, it is not easy to disassemble a battery in operation, and accidents such as explosions may occur during the disassembly process. In other words, it is substantially impossible to disassemble the battery and directly check the state of the positive and negative electrodes. Therefore, there is a need to develop technology to diagnose the state of the battery based on battery-related information using a non-destructive manner.

### DISCLOSURE

### Technical Problem

The present disclosure is designed to solve the problems of the related art, and therefore the present disclosure is directed to providing an apparatus and method for diagnosing a battery, which may diagnose a state of battery in a non-destructive manner.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a differential profile representing the corresponding relationship between a voltage of a battery and a differential capacity for the voltage; and a control unit configured to determine a target peak from the differential profile, determine a first comparison result that compares the voltage between a reference peak of a reference profile preset for the battery and the determined target peak and a second comparison result that compares the differential capacity between the reference peak and the determined target peak, and judge a state of the battery based on the first comparison result and the second comparison result.

The control unit may be configured to determine the first comparison result as a first state or a second state by comparing the magnitude of the voltage between the reference peak and the target peak.

The control unit may be configured to determine the second comparison result as the first state or the second state by comparing the magnitude of the differential capacity between the reference peak and the target peak.

The control unit may be configured to determine the first comparison result as the first state when the voltage of the target peak exceeds the voltage of the reference peak.

The control unit may be configured to determine the first comparison result as the second state when the voltage of the target peak is less than the voltage of the reference peak.

The control unit may be configured to determine the second comparison result as the first state when the differential capacity of the target peak exceeds the differential capacity of the reference peak.

The control unit may be configured to determine the second comparison result as the second state when the differential capacity of the target peak is less than the differential capacity of the reference peak.

The control unit may be configured to judge a state of a positive electrode of the battery based on the first comparison result and the second comparison result.

When the second comparison result is the second state, the control unit may be configured to judge the state of the positive electrode of the battery as a first deterioration state or a second deterioration state based on the first comparison result.

The control unit may be configured to judge the state of the positive electrode of the battery as the first deterioration state when the second comparison result is determined as the second state and the first comparison result is determined as the second state.

The control unit may be configured to judge the state of the positive electrode of the battery as the second deterioration state when the second comparison result is determined as the second state and the first comparison result is determined as the first state.

When the state of the positive electrode is determined as the second deterioration state, the control unit may be configured to reduce at least one of an upper limit of a charging and discharging C-rate and an upper limit of an available SOC preset for the battery or disable the battery.

A battery pack according to another aspect of the present disclosure may comprise the apparatus for diagnosing a battery according to one aspect of the present disclosure.

A method for diagnosing a battery according to still another aspect of the present disclosure may comprise: a differential profile obtaining step of obtaining a differential profile representing the corresponding relationship between a voltage of a battery and a differential capacity for the voltage; a target peak determining step of determining a target peak from the differential profile; a comparison result determining step of determining a first comparison result that compares the voltage between a reference peak of a reference profile preset for the battery and the determined target peak and a second comparison result that compares the differential capacity between the reference peak and the determined target peak; and a battery state judging step of judging a state of the battery based on the first comparison result and the second comparison result.

### Advantageous Effects

According to one aspect of the present disclosure, the apparatus for diagnosing a battery has the advantage of being able to diagnose the electrode state of the battery by considering the peak behavior in the differential profile of the battery. In other words, the apparatus for diagnosing a battery has the advantage of being able to more specifically diagnose the state of the battery in a non-destructive manner.

Additionally, according to one aspect of the present disclosure, the apparatus for diagnosing a battery has the advantage of setting appropriate usage conditions for the current state of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a battery profile according to an embodiment of the present disclosure.
FIG. 3 is a diagram schematically showing a differential profile according to an embodiment of the present disclosure.
FIG. 4 is a diagram schematically showing a reference profile and a differential profile according to an embodiment of the present disclosure.
FIG. 5 is a diagram schematically showing a diagnosis table according to an embodiment of the present disclosure.
FIG. 6 is a diagram schematically showing an exemplary configuration of a battery pack according to another embodiment of the present disclosure.
FIG. 7 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

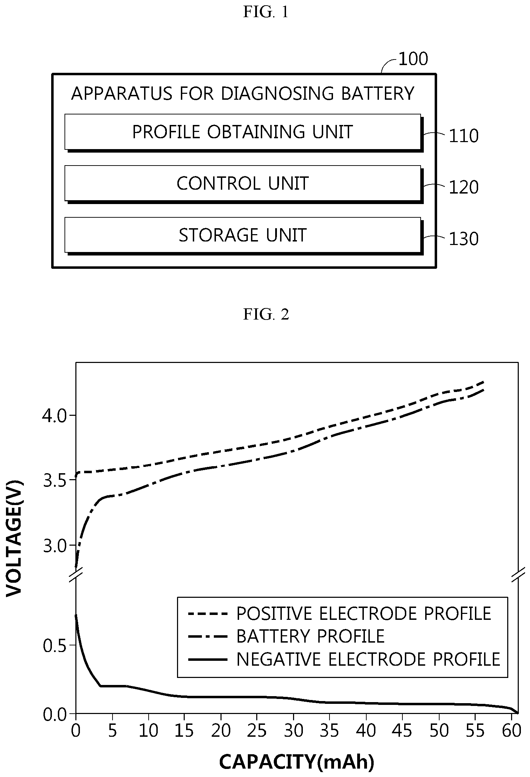

FIG. 1 is a diagram schematically illustrating an apparatus 100 for diagnosing a battery according to an embodiment of the present disclosure. Here, the battery refers to an independent cell that has a negative electrode terminal and a positive electrode terminal and is physically separable. As an example, a lithium-ion cell or a lithium polymer cell may be considered a battery. Additionally, the battery may mean a battery module in which a plurality of cells are connected in series and/or parallel. Hereinafter, for convenience of explanation, the battery is explained as meaning one independent cell.

Referring to FIG. 1, the apparatus 100 for diagnosing a battery may include a profile obtaining unit 110 and a control unit 120.

The profile obtaining unit 110 may be configured to obtain a differential profile representing the corresponding relationship between the voltage of the battery and the differential capacity for the voltage.

Here, the differential capacity is a value obtained by differentiating the capacity of the battery by voltage, and may be expressed as dQ/dV. In other words, the differential capacity may be defined as an instantaneous change rate of capacity with respect to voltage.

In one embodiment, the profile obtaining unit 110 may directly obtain a differential profile from the outside. For example, the profile obtaining unit 110 may obtain a differential profile by receiving a pre-generated differential profile.

In another embodiment, the profile obtaining unit 110 may be configured to obtain a battery profile representing the corresponding relationship between the voltage and capacity of the battery from the outside. Additionally, the profile obtaining unit 110 may obtain a differential profile by directly generating the differential profile from the battery profile.

In still another embodiment, the profile obtaining unit 110 may obtain battery information including the voltage and capacity of the battery. Additionally, the profile obtaining unit 110 may generate a battery profile representing the corresponding relationship between voltage and capacity based on the battery information. Here, the voltage and capacity of the battery may be measured by a measuring device, and the profile obtaining unit 110 may obtain the measured battery information. Additionally, the profile obtaining unit 110 may directly generate a battery profile from the battery information.

In the above, a limited embodiment in which the profile obtaining unit 110 obtains a differential profile has been described. However, the profile obtaining unit 110 may obtain a differential profile for a battery in various ways in addition to the limited embodiment described above.

FIG. 2 is a diagram schematically showing a battery profile according to an embodiment of the present disclosure.

In the embodiment of FIG. 2, the battery profile is a profile representing the corresponding relationship between capacity and voltage of the battery. The battery profile may be expressed as an X-Y graph when X is set to capacity and Y is set to voltage. Also, the positive electrode profile is a profile for the positive electrode of the battery, and the negative electrode profile is a profile for the negative electrode of the battery. Preferably, the profile obtaining unit 110 may obtain the battery profile shown in the embodiment of FIG. 2. Depending on the embodiment, the profile obtaining unit 110 may obtain a positive electrode profile and a negative electrode profile.

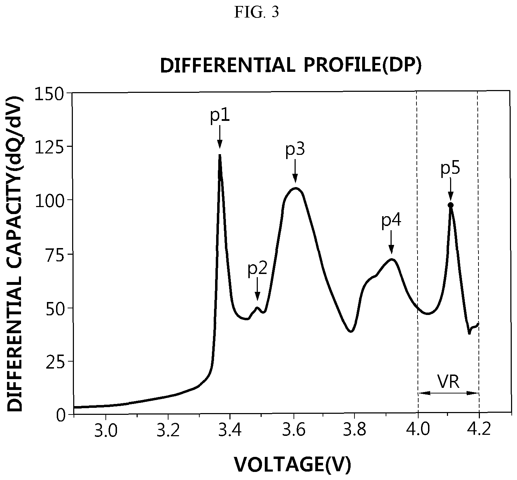

FIG. 3 is a diagram schematically showing a differential profile DP according to an embodiment of the present disclosure.

In the embodiment of FIG. 3, the differential profile DP may be expressed as an X-Y graph when X is set to voltage (V) and Y is set to differential capacity (dQ/dV).

The control unit 120 may be configured to determine the target peak from the differential profile DP.

Specifically, the differential profile DP may include a plurality of peaks. Here, the peak may be a point in the differential profile DP where the slope is 0 and has a convex upward shape. In other words, the peak may be a point where the instantaneous change rate of the differential capacity with respect to voltage is 0 and the slope of the differential profile DP changes from positive to negative. In the embodiment of FIG. 3, the differential profile DP may include a first peak p1, a second peak p2, a third peak p3, a fourth peak p4, and a fifth peak p5.

The control unit 120 may determine the peak belonging to a preset target voltage region VR among the plurality of peaks included in the differential profile DP as the target peak. Here, the preset target voltage region VR may mean the highest voltage region among the overall voltage regions of the battery. For example, in the case of a 4.2 V battery, approximately 4 V to 4.2 V may be set as the target voltage region VR.

More specifically, the target voltage region VR may be preset to a voltage region in which the peak corresponding to the fifth peak p5 appears. The fifth peak p5 is a peak that appears in the differential profile DP of a battery containing nickel. For example, the fifth peak p5 is a peak that appears in the differential profile DP of a high nickel-based battery with a nickel content of 70% or more. Generally, the target voltage region VR, where the fifth peak p5 appears in the differential profile DP of a high nickel-based battery, is known as the voltage region corresponding to the SOC (state of charge) 80% to 100% region of the battery. That is, the voltage region corresponding to SOC 80% to 100% may be preset as the target voltage region VR. Therefore, the control unit 120 may determine the peak belonging to the preset target voltage region VR among the plurality of peaks included in the differential profile DP as the target peak.

In the embodiment of FIG. 3, the control unit 120 may determine the fifth peak p5 among the plurality of peaks p1 to p5 as the target peak.

The control unit 120 may be configured to judge a first comparison result that compares the voltage between a reference peak of a reference profile preset for the battery and the determined target peak and a second comparison result that compares the differential capacity between the reference peak and the determined target peak.

Specifically, the reference profile is a profile that represents the corresponding relationship between voltage and differential capacity for the reference battery. Here, the reference battery may be a battery in the BOL (Beginning of life) state or an experimental battery corresponding to the battery in the BOL state. That is, the reference profile may be set in advance based on the voltage and capacity of the reference battery. Also, among the plurality of peaks included in the reference profile, the peak belonging to the target voltage region VR may be determined as the reference peak.

Preferably, the control unit 120 may determine the first comparison result by comparing the magnitude of the voltage between the reference peak and the target peak, and determine the second comparison result by comparing the magnitude of the differential capacity between the reference peak and the target peak.

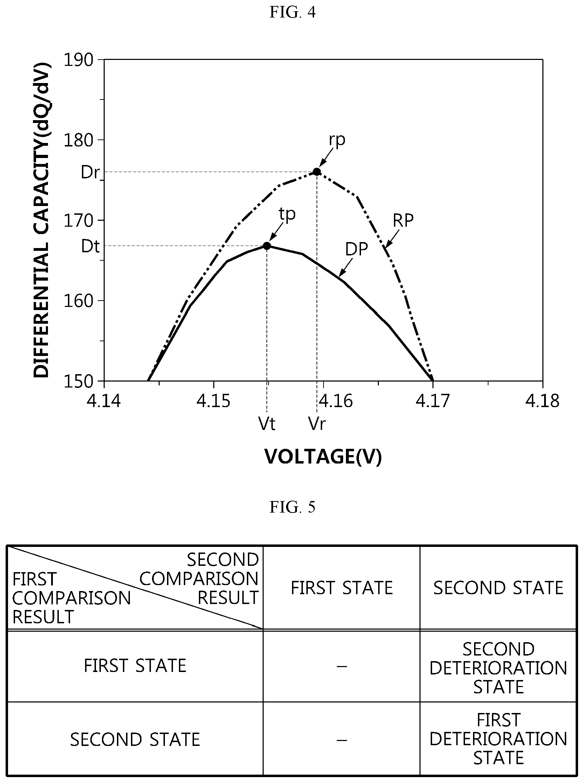

FIG. 4 is a diagram schematically showing a reference profile RP and a differential profile DP according to an embodiment of the present disclosure.

For example, in the embodiment of FIG. 4, it is assumed that the reference profile RP includes the reference peak rp and the differential profile DP includes the target peak tp. At the reference peak rp, the voltage is Vr and the differential capacity is Dr. At the peak target tp, the voltage is Vt and the differential capacity is Dt. The control unit 120 may determine the first comparison result by comparing the voltage Vr of the reference peak rp and the voltage Vt of the target peak tp. Additionally, the control unit 120 may determine the second comparison result by comparing the differential capacity Dr of the reference peak rp and the differential capacity Dt of the target peak tp.

In the embodiment of FIG. 4, the control unit 120 may determine the first comparison result by considering that the voltage Vt of the target peak tp is smaller than the voltage Vr of the reference peak rp. Additionally, the control unit 120 may determine the second comparison result by considering that the differential capacity Dt of the target peak tp is smaller than the differential capacity Dr of the reference peak rp.

The control unit 120 may be configured to judge the state of the battery based on the first comparison result and the second comparison result.

Specifically, the control unit 120 may judge the state of the battery based on a combination of the first comparison result and the second comparison result. For example, the control unit 120 may diagnose the state of the positive electrode of the battery based on the first comparison result and the second comparison result.

The apparatus 100 for diagnosing a battery according to an embodiment of the present disclosure has the advantage of being able to diagnose the electrode state of the battery by considering the peak behavior in the differential profile DP of the battery. In other words, the apparatus 100 for diagnosing a battery has the advantage of being able to diagnose the state of the battery more specifically by diagnosing the state of the positive electrode of the battery in a non-destructive manner.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Below, an embodiment in which the control unit 120 determines the first comparison result and the second comparison result will be described in detail.

The control unit 120 may be configured to determine the first comparison result as a first state or a second state by comparing the magnitude of the voltage between the reference peak rp and the target peak tp.

Specifically, when the voltage of the target peak tp exceeds the voltage of the reference peak rp, the control unit 120 may determine the first comparison result as the first state. Conversely, when the voltage of the target peak tp is less than the voltage of the reference peak rp, the control unit 120 may determine the first comparison result as the second state.

In the embodiment of FIG. 4, since the voltage Vt of the target peak tp is smaller than the voltage Vr of the reference peak rp, the control unit 120 may determine the first comparison result as the second state.

The control unit 120 may be configured to determine the second comparison result as the first state or the second state by comparing the magnitude of the differential capacity between the reference peak rp and the target peak tp.

Specifically, when the differential capacity of the target peak tp exceeds the differential capacity of the reference peak rp, the control unit 120 may determine the second comparison result as the first state. Conversely, if the differential capacity of the target peak tp is less than the differential capacity of the reference peak rp, the control unit 120 may determine the second comparison result as the second state.

In the embodiment of FIG. 4, since the differential capacity Dt of the target peak tp is smaller than the differential capacity Dr of the reference peak rp, the control unit 120 may determine the second comparison result as the second state.

That is, in the first comparison result and the second comparison result, the first state refers to a state in which the current value (e.g., the value of the target peak tp) exceeds the reference value (e.g., the value of the reference peak rp), and the second state refers to a state in which the current value is less than the reference value.

Unlike the embodiment of FIG. 4, when the voltage and differential capacity of the target peak tp exceed the voltage and differential capacity of the reference peak rp, both the first comparison result and the second comparison result may be determined as the first state.

The apparatus 100 for diagnosing a battery according to an embodiment of the present disclosure may independently determine the voltage comparison result (first comparison result) and the differential capacity comparison result (second comparison result) of the target peak tp and the reference peak rp. Additionally, because the state of the battery is diagnosed based on the first comparison result and the second comparison result that are determined independently from each other, the reliability and accuracy of the state diagnosis result may be increased.

Below, an embodiment in which the control unit 120 diagnoses the state of the battery based on the first comparison result and the second comparison result will be described in detail.

FIG. 5 is a diagram schematically showing a diagnosis table according to an embodiment of the present disclosure. Specifically, the diagnosis table in FIG. 5 may be a table used to diagnose the state of the positive electrode of the battery based on the first comparison result and the second comparison result.

In the embodiment of FIG. 5, the control unit 120 may be configured to judge the state of the positive electrode of the battery when the second comparison result is judged as the second state. That is, if the differential capacity Dt of the target peak tp is less than the differential capacity Dr of the reference peak rp, the control unit 120 may judge the state of the positive electrode of the battery based on the first comparison result. Specifically, when the second comparison result is the second state, the control unit 120 may be configured to judge the state of the positive electrode of the battery as a first deterioration state or a second deterioration state based on the first comparison result.

For example, when the voltage Vt of the target peak tp is smaller than the voltage Vr of the reference peak rp (when the first comparison result is the second state), the control unit 120 may diagnose the state of the positive electrode as the first deterioration state.

Here, the first deterioration state represents a state in which cracks have occurred among active material particles inside the battery, and may refer to a state of deterioration (e.g., linear deterioration) of the battery that generally occurs.

As another example, when the voltage Vt of the target peak tp exceeds the voltage Vr of the reference peak rp (when the first comparison result is the first state), the control unit 120 may diagnose the state of the positive electrode as the second deterioration state.

Here, the second deterioration state represents a state in which cracks have occurred inside the active material particles, and may refer to a state in which battery deterioration is accelerated. In this case, there is a problem that gas generation inside the battery may rapidly increase or capacity may drop.

Therefore, the apparatus 100 for diagnosing a battery may quickly diagnose the state of the battery in a non-destructive manner based on the differential capacity comparison result (second comparison result) and voltage comparison result (first comparison result) of the target peak tp and the reference peak rp.

Below, an embodiment in which the control unit 120 controls battery usage conditions based on the judged state of the battery will be described.

Specifically, the control unit 120 may set usage conditions for the battery based on the state of the positive electrode of the battery. Here, the initial usage conditions for the battery may be set in advance. Additionally, the control unit 120 may change the usage conditions according to the judged state of the positive electrode.

When the state of the positive electrode is determined as the second deterioration state, the control unit 120 may reduce at least one of the upper limit of the charging and discharging C-rate and the upper limit of the available SOC preset for the battery. Depending on the embodiment, the control unit 120 may be configured to disable the battery.

For example, when the state of the positive electrode of the battery is the second deterioration state, the control unit 120 may reduce the upper limit of the charging C-rate to prevent further deterioration of the positive electrode. In other words, the control unit 120 may mitigate the conditions for fast charging of the battery. Accordingly, rapid charging of the battery may be prevented, or the rapid charging level (e.g., intensity of rapid charging) may be adjusted downward.

As another example, when the state of the positive electrode of the battery is the second deterioration state, the control unit 120 may reduce the upper limit of the available SOC to prevent further deterioration of the positive electrode. That is, if the state of the positive electrode is a deterioration state, the use of the positive electrode at high SOC (i.e., high potential) may be limited.

As still another example, when the state of the positive electrode of the battery is the second deterioration state, the control unit 120 may be configured to disable the battery. In other words, if the state of the positive electrode of the battery is diagnosed as the second deterioration state, there is a problem that gas generation and/or capacity drop inside the battery may occur due to cracks inside the active material particles. Since internal gas generation causes venting of the battery, accidents such as fire and/or explosion may occur. Accordingly, the control unit 120 may be configured to disable the battery in order to prevent such accidents.

For example, in the embodiment of FIG. 4, the control unit 120 may diagnose the state of the positive electrode of the battery as the first deterioration state. Accordingly, the control unit 120 may not change the preset usage conditions for the battery.

The apparatus 100 for diagnosing a battery according to an embodiment of the present disclosure has the advantage of being able to appropriately set the usage conditions of the battery based on the state of the positive electrode. Because appropriate usage conditions are set for the current state of the battery, further deterioration of the battery may be prevented or delayed. In other words, according to the apparatus 100 for diagnosing a battery, the life expectancy of the battery may be improved.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack 1 according to the present disclosure may include the above-described apparatus 100 for diagnosing a battery and at least one battery cell. Additionally, the battery pack may further include electrical components (relays, fuses, etc.) and a case.

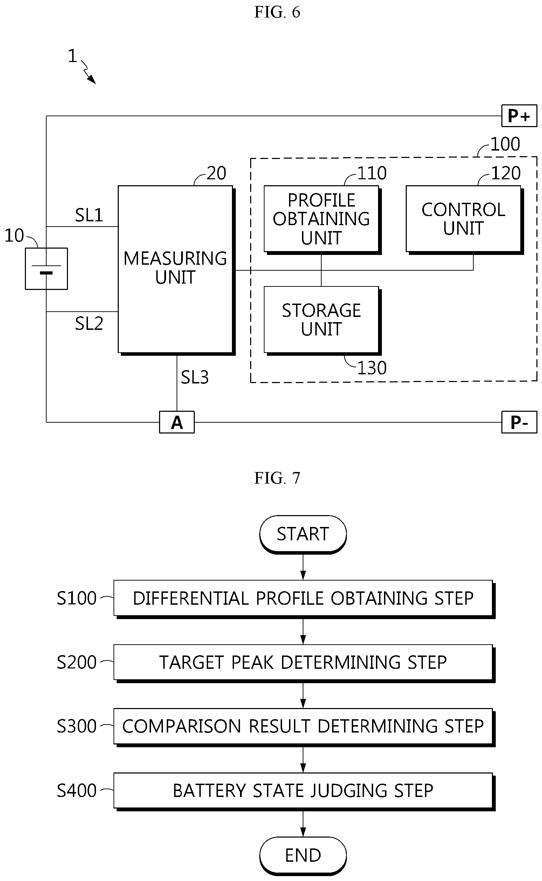

FIG. 6 is a diagram schematically showing an exemplary configuration of a battery pack according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to a first sensing line SL1, a second sensing line SL2, and a third sensing line SL3. Specifically, the measuring unit 20 may be connected to the positive electrode terminal of the battery 10 through the first sensing line SL1, and may be connected to the negative electrode terminal of the battery 10 through the second sensing line SL2. The measuring unit 20 may measure the voltage of the battery 10 based on the voltage measured at each of the first sensing line SL1 and the second sensing line SL2.

Also, the measuring unit 20 may be connected to the current measurement unit A through the third sensing line SL3. For example, the current measurement unit A may be a current meter or a shunt resistance capable of measuring the charging current and discharging current of the battery 10. The measuring unit 20 may calculate the charging amount by measuring the charging current of the battery 10 through the third sensing line SL3. Additionally, the measuring unit 20 may calculate the discharging amount by measuring the discharging current of the battery 10 through the third sensing line SL3.

The charging and discharging device or load may be connected to the positive electrode terminal P+ and the negative electrode terminal P- of the battery pack 1. One end of the load may be connected to the positive electrode terminal P+ of the battery pack 1, and the other end may be connected to the negative electrode terminal P- of the battery pack 1. Accordingly, the positive electrode terminal of the battery 10, the positive electrode terminal P+ of the battery pack 1, the load, the negative electrode terminal P- of the battery pack 1, and the negative electrode terminal of the battery 10 may be electrically connected.

The profile obtaining unit 110 may obtain a battery profile by receiving the voltage and capacity of the battery 10 from the measuring unit 20. Additionally, the profile obtaining unit 110 may generate a differential profile DP from the obtained battery profile.

For example, the battery information including the voltage and capacity of the battery 10 measured by the measuring unit 20 may be stored in the storage unit 130. Additionally, the battery profile and the differential profile DP may also be stored in the storage unit 130.

FIG. 7 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

Referring to FIG. 7, the method for diagnosing a battery may include a differential profile obtaining step (S100), a target peak determining step (S200), a comparison result determining step (S300), and a battery state judging step (S400).

The differential profile obtaining step (S 100) is a step of obtaining a differential profile DP representing the corresponding relationship between the voltage of the battery and the differential capacity for the voltage, and may be performed by the profile obtaining unit 110.

For example, the profile obtaining unit 110 may directly receive the differential profile DP for the battery or generate the differential profile DP based on the battery profile.

The peak target determining step (S200) is a step of determining the target peak tp in the differential profile DP, and may be performed by the control unit 120.

For example, the control unit 120 may determine the peak belonging to the target voltage region VR among the plurality of peaks included in the differential profile DP as the target peak tp.

In the embodiment of FIG. 3, the control unit 120 may determine the fifth peak p5 as the target peak tp among the plurality of peaks p1 to p5 included in the differential profile DP.

The comparison result determining step (S300) is a step of determining the first comparison result that compares the voltage between the reference peak rp of the reference profile RP preset for the battery and the determined target peak tp and the second comparison result that compares the differential capacity between the reference peak rp and the determined target peak tp, and may be performed by the control unit 120.

The control unit 120 may determine the first comparison result by comparing the magnitude of the voltage between the target peak tp and the reference peak rp. Additionally, the control unit 120 may determine the second comparison result by comparing the magnitude of the differential capacity between the target peak tp and the reference peak rp.

For example, if the voltage of the target peak tp exceeds the voltage of the reference peak rp, the first comparison result may be determined as the first state. Conversely, if the voltage of the target peak tp is less than the voltage of the reference peak rp, the first comparison result may be determined as the second state.

As another example, if the differential capacity of the target peak tp exceeds the differential capacity of the reference peak rp, the second comparison result may be determined as the first state. Conversely, if the differential capacity of the target peak tp is less than the differential capacity of the reference peak rp, the second comparison result may be determined as the second state.

Here, the first state refers to a state in which the current value (e.g., the value of the target peak tp) exceeds the reference value (e.g., the value of reference peak rp), and the second state refers to a state in which the current value is less than the reference value.

For example, in the embodiment of FIG. 4, since the voltage Vt of the target peak tp is less than the voltage Vr of the reference peak rp, the first comparison result may be determined as the second state. Also, since the differential capacity Dt of the target peak tp is less than the differential capacity Dr of the reference peak rp, the second comparison result may be determined as the second state.

The battery state judging step (S400) is a step of judging the state of the battery based on the first comparison result and the second comparison result, and may be performed by the control unit 120.

Specifically, the control unit 120 may judge the state of the positive electrode of the battery based on the first comparison result and the second comparison result.

Preferably, when the second comparison result is judged as the second state, the control unit 120 may judge the state of the positive electrode of the battery as the first deterioration state or the second deterioration state based on the first comparison result. In other words, when the differential capacity Dt of the target peak tp is less than the differential capacity Dr of the reference peak rp, the control unit 120 may diagnose the state of the positive electrode according to the result of comparing the voltage Vt of the target peak tp and the voltage Vr of the reference peak rp.

For example, if the second comparison result is the second state and the first comparison result is the second state, the control unit 120 may judge the state of the positive electrode of the battery as the first deterioration state. Conversely, when the second comparison result is the second state and the first comparison result is the first state, the control unit 120 may judge the state of the positive electrode of the battery as the second deterioration state.

For example, in the embodiment of FIG. 4, the first comparison result is the second state, and the second comparison result is the second state. Accordingly, the control unit 120 may diagnose the state of the positive electrode of the battery as the first deterioration state.

Depending on the embodiment, the control unit 120 may prevent the battery from further deteriorating by setting usage conditions for the battery based on the diagnosis result.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery
100: apparatus for diagnosing a battery
110: profile obtaining unit
120: control unit
130: storage unit

## Claims

1. An apparatus for diagnosing a battery, comprising:
a profile obtaining unit configured to obtain a differential profile representing the corresponding relationship between a voltage of a battery and a differential capacity for the voltage; and
a control unit configured to determine a target peak from the differential profile, determine a first comparison result that compares the voltage between a reference peak of a reference profile preset for the battery and the determined target peak and a second comparison result that compares the differential capacity between the reference peak and the determined target peak, and judge a state of the battery based on the first comparison result and the second comparison result.

2. The apparatus for diagnosing a battery according to claim 1,
wherein the control unit is configured to determine the first comparison result as a first state or a second state by comparing the magnitude of the voltage between the reference peak and the target peak, and
wherein the control unit is configured to determine the second comparison result as the first state or the second state by comparing the magnitude of the differential capacity between the reference peak and the target peak.

3. The apparatus for diagnosing a battery according to claim 2,
wherein the control unit is configured to determine the first comparison result as the first state when the voltage of the target peak exceeds the voltage of the reference peak, and
wherein the control unit is configured to determine the first comparison result as the second state when the voltage of the target peak is less than the voltage of the reference peak.

4. The apparatus for diagnosing a battery according to claim 2,
wherein the control unit is configured to determine the second comparison result as the first state when the differential capacity of the target peak exceeds the differential capacity of the reference peak, and
wherein the control unit is configured to determine the second comparison result as the second state when the differential capacity of the target peak is less than the differential capacity of the reference peak.

5. The apparatus for diagnosing a battery according to claim 2,
wherein the control unit is configured to judge a state of a positive electrode of the battery based on the first comparison result and the second comparison result.

6. The apparatus for diagnosing a battery according to claim 5,
wherein when the second comparison result is the second state, the control unit is configured to judge the state of the positive electrode of the battery as a first deterioration state or a second deterioration state based on the first comparison result.

7. The apparatus for diagnosing a battery according to claim 6,
wherein the control unit is configured to judge the state of the positive electrode of the battery as the first deterioration state when the second comparison result is determined as the second state and the first comparison result is determined as the second state, and
wherein the control unit is configured to judge the state of the positive electrode of the battery as the second deterioration state when the second comparison result is determined as the second state and the first comparison result is determined as the first state.

8. The apparatus for diagnosing a battery according to claim 7,
wherein when the state of the positive electrode is determined as the second deterioration state, the control unit is configured to reduce at least one of an upper limit of a charging and discharging C-rate and an upper limit of an available SOC preset for the battery or disable the battery.

9. A battery pack, comprising the apparatus for diagnosing a battery according to any one of claims 1 to 8.

10. A method for diagnosing a battery, comprising:
a differential profile obtaining step of obtaining a differential profile representing the corresponding relationship between a voltage of a battery and a differential capacity for the voltage;
a target peak determining step of determining a target peak from the differential profile;
a comparison result determining step of determining a first comparison result that compares the voltage between a reference peak of a reference profile preset for the battery and the determined target peak and a second comparison result that compares the differential capacity between the reference peak and the determined target peak; and
a battery state judging step of judging a state of the battery based on the first comparison result and the second comparison result.
